(19) **Europäisches Patentamt European Patent Office Office européen des brevets**

(11) **EP 1 473 839 B1**

(12) **FASCICULE DE BREVET EUROPEEN**

(45) Date de publication et mention
de la délivrance du brevet:
**19.03.2008 Bulletin 2008/12**

(51) Int Cl.:
*H03M 13/00* (2006.01)   *H04L 1/00* (2006.01)

(21) Numéro de dépôt: **04290849.1**

(22) Date de dépôt: **31.03.2004**

(54) **Procédé et dispositif de réception de blocs de données avec correction et detection d'erreurs**

Verfahren und Vorrichtung zum Empfang von Datenblöcken mit Fehlerkorrektur und -erkennung

Data block reception method and device with error correction and error detection

(84) Etats contractants désignés:
**DE FR GB**

(30) Priorité: **30.04.2003 FR 0305328**

(43) Date de publication de la demande:
**03.11.2004 Bulletin 2004/45**

(73) Titulaire: **Nortel Networks Limited
St Laurent, Québec H4S 2A9 (CA)**

(72) Inventeurs:
• **Ben Rached, Nidham
75017 Paris (FR)**
• **Cayla, Stéphane
78220 Viroflay (FR)**
• **De Lannoy, Arnaud
78000 Versailles (FR)**

(74) Mandataire: **Loisel, Bertrand
Cabinet Plasseraud
52 rue de la Victoire
75440 Paris Cedex 09 (FR)**

(56) Documents cités:
**EP-A- 0 897 228      US-A1- 2002 015 405**

**Description**

La présente invention concerne les techniques de communication numérique, et plus particulièrement la réception de blocs de données dans lesquels sont insérés des codes de détection d'erreurs.

Il est très courant de prévoir de tels codes dans des formats de blocs de données transmis. Ce sont généralement des codes adjoints aux données du bloc par application d'un codage cyclique systématique. On parle de codes de vérification de parité ou de CRC ("cyclic redundancy checksum").

L'invention vise plus particulièrement des systèmes où il est prévu aux moins deux codes de cette nature au sein d'un bloc de données, pour vérifier l'intégrité de parties distinctes du bloc: un en-tête et un ou plusieurs champs de données.

Souvent, les informations contenues dans l'entête d'un bloc sont plus importantes que celles contenues dans les champs de données. L'en-tête peut ainsi spécifier des informations utiles à la réception du reste des données du bloc ou au bon fonctionnement du récepteur (identification du destinataire du bloc, format des données, modulation, codage correcteur d'erreur appliqué, informations utiles aux protocoles de couche liaison, etc.). Pour protéger davantage ces informations, on applique à l'en-tête un schéma de codage plus robuste aux erreurs et on le munit d'un CRC distinct de celui utilisé pour le champ de données.

Une telle distinction est par exemple prévue pour la transmission de données dans le système de radiocommunication cellulaire de type EGPRS ("Enhanced General Packet Radio Service"), normalisé par l'ETSI ("European Télécommunications Standards Institute"). Ce système permet de transmettre, entre une station de base et une station mobile, des blocs de signal modulé pouvant faire l'objet de plusieurs modulations et de plusieurs codages correcteurs d'erreurs de transmission. La modulation et le codage sont sélectionnés bloc par bloc par le choix d'un schéma de modulation et de codage MCS ("Modulation and Coding Scheme") parmi neuf schémas MCS-1 à MCS-9 spécifiés dans la norme européenne ETSI EN 300 909, Digital cellular telecommunications system (Phase 2+) : Channel coding (GSM 05.03, version 8.5.1, Release 1999), publiée par l'ETSI en novembre 2000. Chacun de ces schémas offre un niveau de protection des données plus ou moins robuste et corrélativement un débit d'information plus ou moins important.

L'en-tête d'un bloc radio EGPRS comporte un CRC de huit bits, tandis que son champ de données comporte un CRC de douze bits.

Le choix du schéma de modulation et de codage appliqué à un bloc résulte d'un algorithme d'adaptation de lien dont les variables d'entrée comprennent, pour chaque station mobile, des paramètres représentant la qualité de réception observée par le récepteur (la station mobile dans le sens descendant ou la station de base dans le sens montant). Une qualité médiocre (taux d'erreur binaire élevé) témoigne de conditions de propagation difficiles, et requiert une augmentation de la protection contre les erreurs pour le mobile concerné et donc une réduction du débit utile.

La présence d'un bloc provenant d'une station mobile donnée ou destiné à celle-ci est décidée par le récepteur lorsque le CRC de l'en-tête est correct et que le contenu de l'en-tête désigne cette station mobile. Cette décision permet de mettre à jour les estimateurs de qualité pertinents.

La taille du CRC de l'en-tête (8 bits) donne lieu à une probabilité de fausse détection de 1/256, soit environ une fois toutes les 5 secondes. Lorsqu'une telle fausse détection survient, l'adaptation de lien relative à la station mobile désignée dans l'en-tête est perturbée. En particulier, si aucun bloc n'était transmis (bruit seulement), l'indicateur de qualité pour la station mobile en question se dégrade, de sorte qu'elle subit une diminution de débit utile, alors qu'elle bénéficie peut-être d'excellentes conditions radio.

Les techniques d'adaptation de lien ne sont pas les seules qui peuvent être perturbées par la fausse détection de blocs de données. Par exemple, c'est le cas aussi des techniques de répétition automatique de blocs (ARQ) avec redondance incrémentale (IR). Dans ces techniques, les données d'un bloc mal décodé par le récepteur sont conservées par celui-ci et une répétition en est demandée. Les données conservées enrichissent alors celles obtenues à la suite de la répétition afin d'augmenter la probabilité de détection. Il importe d'éviter qu'un bloc soit détecté par erreur en présence de bruit seulement car cela peut introduire de la confusion dans le contrôle des émissions de blocs.

Ces inconvénients peuvent être atténués en augmentant la taille du CRC de l'en-tête. Mais c'est au détriment du débit de transmission, et ce n'est pas possible dans un système dont les formats sont déjà normalisés.

Un but de la présente invention est de minimiser les risques de fausse détection de tels blocs ayant plusieurs codes de détection d'erreurs.

L'invention propose ainsi un procédé de réception de blocs de données comprenant chacun un en-tête et un champ de données incluant respectivement des premier et second codes de détection d'erreurs, comprenant les étapes suivantes:

- décoder une première portion d'un signal reçu;
- ignorer le signal reçu si le signal décodé de la première portion présente un premier code incorrect; et
- si le signal décodé de la première portion présente un premier code correct, déterminer un en-tête de bloc d'après la première portion et pour au moins une valeur de cet en-tête de bloc:

  • décoder une seconde portion du signal reçu;
  • si le signal décodé de la seconde portion présente un second code correct, valider l'en-tête de bloc et un champ de données correspondant déterminé d'après la seconde portion; et

- si le signal décodé de la seconde portion présente un second code incorrect, valider l'en-tête de bloc si un paramètre de vraisemblance évalué lors du décodage de la seconde portion remplit un critère de validation et rejeter l'en-tête de bloc si le paramètre de vraisemblance ne remplit pas le critère de validation.

Une détection fortuite d'un en-tête de bloc en présence de bruit seulement sera généralement évitée grâce au critère de vraisemblance appliqué. Ce critère ne sera pas rempli en présence de bruit seulement tandis que la réception dans de mauvaises conditions d'un bloc pertinent (premier code correct mais second code incorrect) donnera généralement lieu à une vraisemblance supérieure à celle observée en présence de bruit seul. Le critère peut ainsi consister à comparer le paramètre de vraisemblance à un seuil convenablement choisi, fixe ou adaptatif.

Un autre aspect de l'invention se rapporte à un dispositif de réception de blocs de données comprenant des moyens de traitement agencés pour mettre en oeuvre un procédé tel que défini ci-dessus. L'invention propose aussi une station de base de radiocommunication cellulaire ainsi qu'une station mobile, incluant un tel dispositif de réception de blocs de données.

D'autres particularités et avantages de la présente invention apparaîtront dans la description ci-après d'exemples de réalisation non limitatifs, en référence aux dessins annexés, dans lesquels :

- la figure 1 est un schéma d'un réseau de type GPRS auquel l'invention peut s'appliquer;
- la figure 2 est un exemple de schéma synoptique d'une unité de contrôle de paquets d'un tel réseau; et
- les figures 3 et 4 sont des organigrammes de procédures de réception de blocs selon deux modes de réalisation de l'invention.

L'invention est décrite ci-après dans son application non limitative à des réseaux de type EGPRS. Ces réseaux sont développés pour la transmission de données en mode paquets dans des réseaux cellulaires de type GSM ("Global System for Mobile communications").

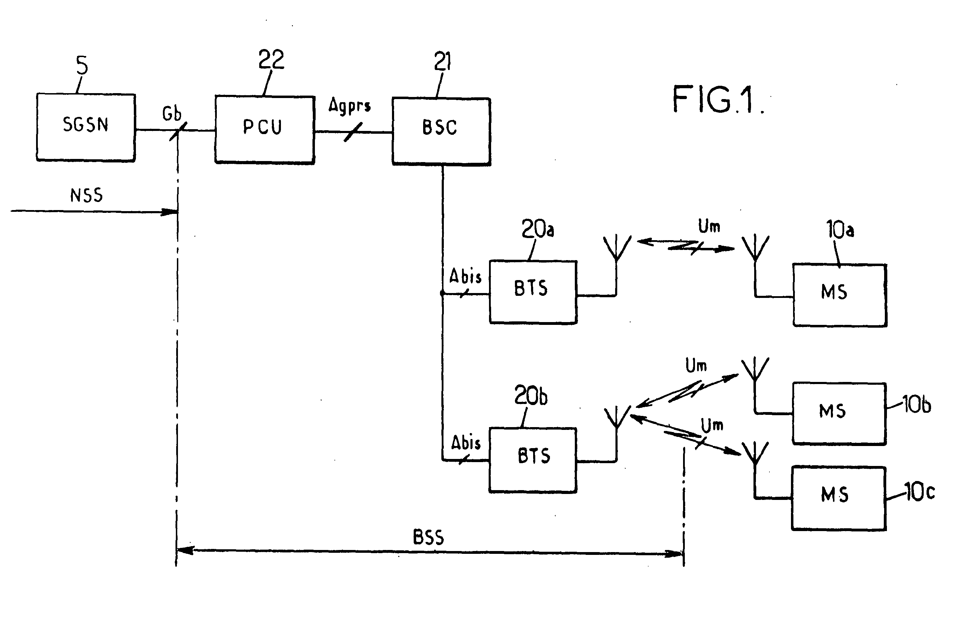

Le réseau EGPRS illustré sur la figure 1 est bâti sur une infrastructure GSM, et classiquement divisé en un coeur de réseau, aussi appelé sous-système de réseau et de commutation ou NSS ("Network and Switching Subsystem"), et un réseau d'accès radio également appelé sous-système de stations de base ou BSS ("Base Station Subsystem").

Pour le service de paquets, les commutateurs du NSS sont appelés noeuds de support GPRS ou GSN ("GPRS Support Node"). On distingue les SGSN ("Serving GSN") 5 qui sont reliés au BSS par l'intermédiaire d'une interface appelée Gb, et les GGSN ("Gateway GSN", non représentés) qui servent de passerelle avec des réseaux externes de transmission de paquets, tels que le réseau Internet par exemple.

Une description générale de l'interface radio. appelée Um, entre les stations mobiles (MS) 10a-10b-10c et les stations de base (BTS) 20a-20b du BSS est fournie dans la spécification technique ETSI TS 101 350, "Digital cellular telecommunications system (Phase 2+) ; General Packet Radio Service (GPRS) ; Overall description of the GPRS radio interface ; Stage 2" (GSM 03.64, version 8.5.0, Release 1999), publiée par l'ETSI en août 2000.

Chaque station de base 20a-20b est supervisée par un contrôleur de stations de base ou BSC ("Base Station Controller") 21 par l'intermédiaire d'une interface appelée Abis. Pour gérer la transmission de paquets GPRS, le BSS comprend en outre une unité de contrôle de paquets (PCU) 22. La localisation du PCU à l'intérieur du BSS n'est pas normalisée. Dans l'exemple représenté sur la figure 1, le PCU 22 est situé entre te BSC 21, avec lequel il communique à travers une interface appelée Agprs, et le NSS, avec lequel il communique à travers l'interface Gb.

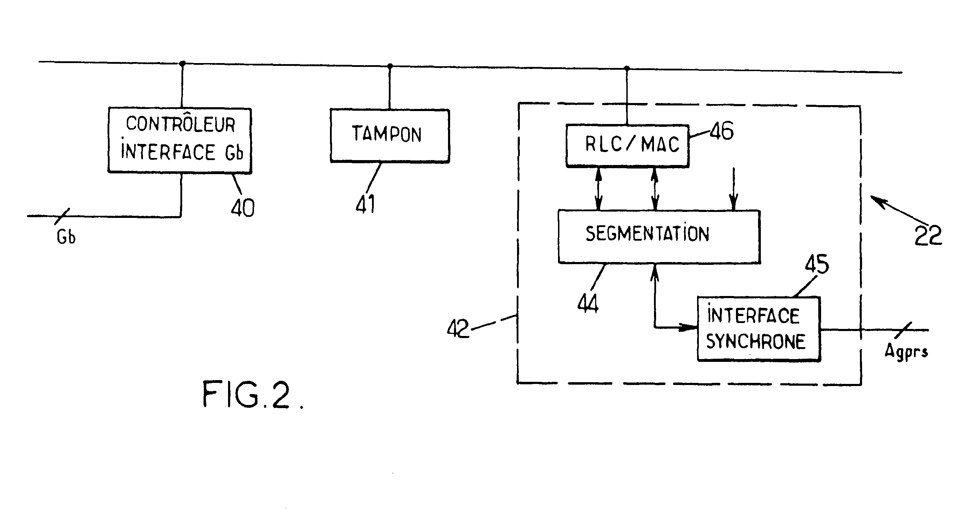

La figure 2 illustre une structure possible d'un PCU 22 situé entre un SGSN 5 et un BSC 21, comme dans l'exemple de la figure 1. La référence 40 désigne le contrôleur d'interface Gb pour la liaison avec le SGSN 5. Les données manipulées par le PCU 22 entre le contrôleur d'interface Gb 40 et te contrôleur d'interface Agprs 42 transitent par une mémoire tampon 41 où sont enregistrées des files d'attente de paquets.

Entre le PCU 22 et les BTS 20a-20b, les informations sont portées par des trames de type TRAU ("Transcoder/Rate Adaptor Unit") de 320 bits. Ces trames TRAU sont mises en forme et traitées par un module 44 et transmises par l'intermédiaire de circuits d'interface synchrone 45 qui réalisent des sous-voies MIC à 16 kbit/s avec les BTS 20a-20b. Plusieurs canaux (sous-voies) à 16 kbit/s sont multiplexés dans le temps sur l'interface Agprs et commutés par le BSC 21 pour l'acheminement vers les BTS.

Un module 46 du contrôleur d'interface Agprs 42 met en oeuvre les protocoles radio de la couche 2 du modèle ISO, à savoir les protocoles RLC/MAC ("Radio Link Control / Médium Access Control") décrits dans la norme européenne ETSI EN 301 349, "Digital cellular telecommunications system (Phase 2+) ; General Packet Radio Service (GPRS) ; Mobile Station (MS) - Base Station System (BSS) interface ; Radio Link Control/Medium Access Control (RLC/MAC) protocol" (GSM 04.60. version 8.3.1, Release 1999), publiée par l'ETSI en octobre 2000.

La sous-couche RLC réalise l'interface avec le protocole de couche supérieure, appelé LLC ("Logical Link Control"). Elle assure la segmentation et le réassemblage des unités de données du protocole LLC (LLC-PDU). La sous-couche MAC gère le multiplexage des blocs relevant des différents flux de blocs temporaire (TBF, "Temporary Block Flow") actifs sur tes canaux physiques disponibles, en arbitrant entre les différents utilisateurs mobiles par un mécanisme de planification (scheduling).

Le format des blocs RLC/MAC utilisé dans un système EGPRS est décrit dans la norme européenne ETSI EN 301 349 précitée. Neuf schémas de modulation et de codage, appelés MCS-1 à MCS-9, sont prévus. ils correspondent à des schémas de protection contre les erreurs de transmission. Le schéma utilisé pour un bloc donné, ainsi qu'un schéma de poinçonnage éventuellement appliqué, sont indiqués dans un champ CPS ("Coding and Puncturing Scheme indicator") de l'en-tête RLC/MAC EGPRS. Chaque bloc RLC contient un nombre d'octets dépendant du schéma de modulation et de codage retenu pour ce bloc. Un bloc peut être transmis toutes les 20 ms par canal physique.

L'en-tête RLC/MAC EGPRS fait l'objet d'un codage de canal distinct de celui des données du bloc. Le niveau de protection de cet en-tête contre les erreurs de transmission est plus élevé que celui des données pour assurer une meilleure robustesse des informations de signalisation. L'en-tête comprend notamment les éléments suivants:

- l'indicateur de flux de transport (TFI) qui identifie le TBF dont relève le bloc et donc la MS qui en est le destinataire (dans le sens descendant) ou l'émetteur (dans le sens montant);
- le CPS;
- des informations utiles au mécanisme d'ARQ mis en oeuvre dans la couche RLC;
- un code de détection d'erreur de huit bits, ci-après noté CRC1.

En plus de cet en-tête, le bloc RLC/MAC comporte un champ de données incluant un CRC de douze bits. ci-après noté CRC2, pour détecter les données mal reçues.

La spécification technique TS 100 911, version 8.13.0, "Digital cellular telecommunications system (Phase 2+) ; Radio Subsystem Link Control" (3GPP TS 05.08 Release 1999), publiée en février 2002 par l'organisme 3GPP ("3rd Generation Partnership Project") décrit les mesures radio à réaliser par les BTS et les MS sur des signaux reçus. Ces mesures regroupent des niveaux et des indicateurs de qualité des signaux. Parmi ceux-ci, le système EGPRS prévoit le calcul par une MS, sur une liaison descendante et pour chacune des deux modulations possibles (GMSK et 8-PSK), d'indicateurs liés à la probabilité d'erreur binaire (BEP, "bit error probability") sur un bloc radio. Parmi ceux-ci, on trouve notamment le MEAN_BEP qui est une moyenne de la probabilité d'erreur binaire sur un bloc radio, et le CV_BEP qui est un coefficient de variation de la probabilité d'erreur binaire sur un bloc radio, soit

$$CV\_BEP = \frac{\sqrt{variance(BEP)}}{MEAN\_BEP}$$

. Le BEP se dégrade brutalement lorsqu'un bloc est détecté par erreur par la MS alors que rien n'était transmis par la BTS.

Pour les liaisons montantes, des mesures analogues peuvent être faites par la BTS relativement à chaque MS.

La MS pour laquelle les indicateurs liés au BEP sont à mettre à jour suite à la détection d'un bloc est celle qui correspond au TFI inclus dans l'entête du bloc.

Les mesures effectuées par la MS (par exemple la MS 10a de la figure 1) sont remontées au PCU 22 dans un message PACKET DOWNLINK ACK/NACK, comme spécifié au paragraphe 11.2.6a de la norme EN 301 349 précitée. Les mesures effectuées par la BTS (par exemple la BTS 20a de la figure 1) sont, quant à elles, transmises au PCU 22 dans une trame TRAU.

Le PCU 22 met en oeuvre un algorithme d'adaptation de lien pour sélectionner un schéma de codage et de modulation pour chaque lien radio, sur la base des mesures qui lui ont été remontées. Il dispose par exemple de tables qui donnent une correspondance entre un couple (MEAN_BEP, CV_BEP) et un des schémas MCS-1 à MCS-9. Il importe donc que cet algorithme soit exécuté sur des paramètres d'entrée pertinents, notamment le MEAN_BEP qui est le plus sensible.

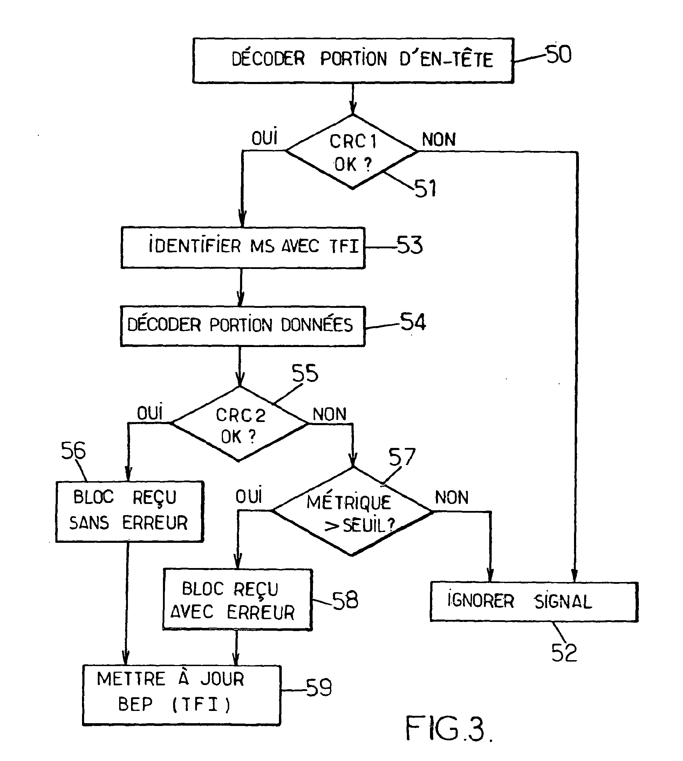

La figure 3 montre la procédure que peut appliquer la BTS à réception d'un segment de signal radio susceptible de correspondre à un bloc de données RLC/MAC si une MS a émis un tel bloc dans la période considérée. Compte tenu de la traduction (mapping) des blocs RLC/MAC sur la couche physique, ce segment de signal est récupéré dans quatre rafales radio sur un canal physique. Après désentrelacement du segment de signal, celui-ci comporte une portion d'en-tête où se trouve l'en-tête de l'éventuel bloc émis et une portion de données où se trouve le reste des données de l'éventuel bloc.

A l'étape 50, la BTS procède au décodage canal de la portion d'en-tête conformément au code appliqué par la MS (cf. norme ETSI EN 300 909 précitée). Elle vérifie ensuite si le CRC1 recalculé concorde avec celui figurant dans l'en-tête décodé (test 51). Si le CRC1 est incorrect, le segment de signal est ignoré (étape 52), la BTS considérant qu'elle n'a capté que du bruit. Si le CRC1 est correct, la BTS identifie la MS à l'aide du TFI trouvé dans l'en-tête décodé (étape 53) puis elle décode la portion de données du segment de signal (étape 54) conformément au code indiqué dans le champ CPS de l'en-tête décodé. Elle vérifie ensuite si le CRC2 recalculé concorde avec celui figurant dans le champ de données décodé (test 55).

Si le CRC2 est correct, le bloc RLC/MAC est déclaré reçu sans erreur (étape 56). Sinon, un test supplémentaire 57 est effectué pour évaluer un critère de vraisemblance.

Le décodage 54 étant réalisé à l'aide d'un décodeur à treillis de Viterbi adapté au code convolutif appliqué par la MS, ce décodeur est capable de fournir avec les valeurs des symboles estimés une valeur de métrique qui a été optimisée dans le treillis (voir G.D. Forney, "The Viterbi Algorithm", Proc. IEEE, Vol. 61, No. 3, mars 1973, pp. 268-278). Cette métrique est indicative de la vraisemblance des symboles décodés. Le test 57 consiste à la comparer à un seuil prédéterminé.

Si ce seuil n'est pas atteint. la BTS ignore le segment de signal, considérant avoir observé de façon fortuite une valeur correcte du CRC1 en présence de bruit. Si la métrique du décodeur de Viterbi dépasse le seuil du test 57, la BTS considère par contre qu'elle a effectivement reçu un bloc en provenance de la MS associée au TFI, mais qu'elle l'a reçu dans de mauvaises conditions (CRC2 faux). Elle déclare alors le bloc reçu, mais avec une erreur (étape 58) de sorte que ce bloc ne sera pas acquitté. Après l'étape 56 ou 58, la BTS procède à la mise à jour 59 de l'estimateur BEP pour la MS associée au TFI pour que les indicateurs MEAN_BEP et CV_BEP soient envoyés au PCU le moment venu. En revanche, cette mise à jour 59 n'a pas lieu après l'étape 52, notamment lorsque le critère de vraisemblance n'est pas vérifié au test 57.

La probabilité de fausse détection d'un bloc est faible lorsque le seuil de l'étape 57 est haut. Mais il ne faut pas le prendre trop haut pour éviter de rejeter des blocs qui ont effectivement été reçus. Sur une échelle de métrique normalisée à 1, un seuil de 0,7 diminue la probabilité de fausse détection de 10% et un seuil de 0,82 diminue cette probable de 99%. Une valeur préférée du seuil à 0,78 diminue la probabilité de 90%.

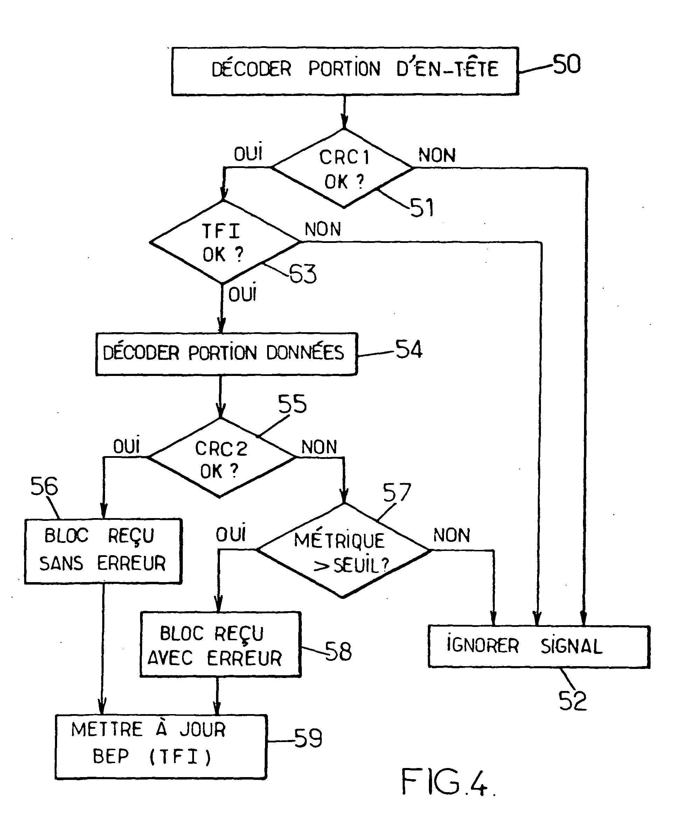

Le traitement appliqué par les MS pour la réception de blocs descendants est illustré par la figure 4. Il est très semblable à celui de la figure 3. La différence est que lorsque le CRC1 est correct, la MS vérifie simplement à l'étape 63 si le TFI lui est bien alloué. Le segment de signal est ignoré si c'est une autre MS qui est concernée. Si le TFI concerne bien la MS, celle-ci décode la portion de données du segment de signal et poursuit comme indiqué en référence à la figure 3.

Dans une application de l'invention à un mécanisme d'ARQ avec redondance incrémentale, l'étape 56 donne lieu à un acquittement du bloc, tandis que l'étape 58 donne lieu à une mémorisation des symboles décodés du bloc et à une requête de répétition. Les blocs éliminés par le test 57 ne viennent pas perturber le mécanisme d'ARQ.

## Revendications

1. Procédé de réception de blocs de données comprenant chacun un en-tête et un champ de données incluant respectivement des premier et second codes de détection d'erreurs, comprenant les étapes suivantes:

- décoder (50) une première portion d'un signal reçu;
- ignorer (52) le signal reçu si le signal décodé de la première portion présente un premier code de détection d'erreurs incorrect; et
- si le signal décodé de la première portion présente un premier code de détection d'erreurs correct, déterminer un en-tête de bloc d'après la première portion et pour au moins une valeur de cet en-tête de bloc:

  • décoder (54) une seconde portion du signal reçu;
  • si (55) signal décodé de la seconde portion présente un second code de détection d'erreurs correct, valider (56) l'en-tête de bloc et un champ de données correspondant déterminé d'après la seconde portion; et de détection d'erreurs
  • si (55) le signal décodé de la seconde portion présente un second code de détection d'erreurs incorrect, valider (58) l'en-tête de bloc si (57) un paramètre de vraisemblance évalué lors du décodage de la seconde portion remplit un critère de validation et rejeter l'en-tête de bloc si le paramètre de vraisemblance ne remplit pas le critère de validation.

2. Procédé selon la revendication 1, dans lequel lorsque le signal décodé de la première portion présente un premier code correct, on identifie une station de communication sur la base de l'en-tête de bloc déterminé.

3. Procédé selon la revendication 2, dans lequel lorsque le signal décodé de la première portion présente un premier code correct, on ne poursuit le traitement du signal reçu que si la station identifiée est celle ou ledit signal est reçu.

4. Procédé selon la revendication 2, dans lequel lorsque le signal décodé de la première portion présente un premier code correct, on poursuit le traitement du signal en relation avec la station identifiée.

5. Procédé selon l'une quelconque des revendications précédentes, dans lequel le paramètre de vraisemblance découle d'une métrique d'un décodeur de Viterbi.

6. Procédé selon l'une quelconque des revendications précédentes, dans lequel le premier code de détection d'erreurs est de huit bits.

7. Procédé selon l'une quelconque des revendications précédentes, dans lequel ledit signal est reçu sur une interface radio.

**8.** Dispositif de réception de blocs de données comprenant des moyens de traitement agencés de manière à mettre en oeuvre chacune des étapes d'un procédé selon l'une quelconque des revendications précédentes.

**9.** Station de base de radiocommunication cellulaire, incluant un dispositif de réception de blocs de données selon la revendication 8.

**10.** Station mobile de radiocommunication cellulaire, incluant un dispositif de réception de blocs de données selon la revendication 8.


**Claims**

**1.** A method for receiving data blocks each comprising a header and a data field including respectively first and second codes for error detection, comprising the steps of:

- decoding (50) a first portion of a signal received;
- ignoring (52) the signal received if the decoded signal of the first portion has an incorrect first code; and
- if the decoded signal of the first portion has a correct first code for error detection, determining a block header in accordance with the first portion, and for at least one value of this block header:

• decoding (54) a second portion of the signal received;
• if (55) the decoded signal of the second portion has a correct second code for error detection, validating (56) the block header and a corresponding data field determined in accordance with the second portion; and
• if (55) the decoded signal of the second portion has an incorrect second code for error detection, validating (58) the block header if (57) a likelihood parameter evaluated during the decoding of the second portion fulfils a validation criterion and rejecting the block header if the likelihood parameter does not fulfil the validation criterion.

**2.** The method as claimed in Claim 1, wherein when the decoded signal of the first portion has a correct first code, a communication station is identified on the basis of the determined block header.

**3.** The method as claimed in Claim 2, wherein when the decoded signal of the first portion has a correct first code, the processing of the signal received is continued only if the identified station is that where said signal is received.

**4.** The method as claimed in Claim 2, wherein when the decoded signal of the first portion has a correct first code, the processing of the signal is continued in relation to the identified station.

**5.** The method as claimed in any one of the preceding claims, wherein the likelihood parameter stems from a metric of a Viterbi decoder.

**6.** The method as claimed in any one of the preceding claims, wherein the first code for error detection is of 8 bits.

**7.** The method as claimed in any one of the preceding claims, wherein said signal is received on a radio interface.

**8.** A device for receiving data blocks comprising processing means devised so as to implement each of the steps of a method according to any one of the preceding claims.

**9.** A cellular radio communication base station, including a device for receiving data blocks according to Claim 8.

**10.** A cellular radio communication mobile station, including a device for receiving data blocks according to Claim 8.


**Patentansprüche**

**1.** Verfahren zum Empfang von Datenblöcken, wobei jeder Datenblock eine Kopfzeile sowie ein Datenfeld mit jeweils einem ersten und einem zweiten Code zur Erkennung von Fehlern beinhaltet, umfassend die folgenden Verfahrensschritte:

- Entschlüsselung (50) eines ersten Teils eines empfangenen Signals;
- Ignorieren (52) des empfangenen Signals, wenn das entschlüsselte Signal des ersten Teils einen inkorrekten ersten Fehlererkennungs-Code aufweist; und
- wenn das entschlüsselte Signal des ersten Teils einen korrekten ersten Fehlererkennungs-Code aufweist, Bestimmen einer Block-Kopfzeile in Übereinstimmung mit dem ersten Teil sowie für wenigstens einen Wert dieser Block-Kopfzeile:

■ Dekodieren (54) eines zweiten Teils des empfangenen Signals;
■ wenn (55) das entschlüsselte Signal des zweiten Teils einen korrekten zweiten Fehlererkennungs-Code aufweist, Validierung (56) der Block-Kopfzeile und eines entsprechenden Datenfelds, welches in Übereinstimmung mit dem zweiten Teil ermittelt wurde; und

■ wenn (55) das entschlüsselte Signal des zweiten Teils einen inkorrekten zweiten Fehlererkennungs-Code aufweist, Validierung (58) der Block-Kopfzeile, wenn (57) ein Wahrscheinlichkeits-Parameter, der während des Entschlüsselns des zweiten Teils evaluiert wurde, ein Validierungs-Kriterium erfüllt, und Verwerfen der Block-Kopfzeile, wenn der Wahrscheinlichkeits-Parameter nicht das Validierungs-Kriterium erfüllt.

2. Verfahren nach Anspruch 1, wobei, wenn das entschlüsselte Signal des ersten Teils einen korrekten ersten Code aufweist, eine Kommunikations-Station auf der Basis der bestimmten Block-Kopfzeile identifiziert wird.

3. Verfahren nach Anspruch 2, wobei, wenn das entschlüsselte Signal des ersten Teils einen korrekten ersten Code aufweist, die Verarbeitung des empfangenen Signals nur dann fortgesetzt wird, wenn die identifizierte Station diejenige ist, wo das besagte Signal empfangen wurde.

4. Verfahren nach Anspruch 2, wobei, wenn das entschlüsselte Signal des ersten Teils einen korrekten ersten Code aufweist, die Verarbeitung des Signals in Bezug auf die identifizierte Station fortgesetzt wird.

5. Verfahren nach einem der vorangegangenen Ansprüche, wobei der Wahrscheinlichkeits-Parameter von der Metrik eines Viterbi-Dekoders abstammt.

6. Verfahren nach einem der vorangegangenen Ansprüche, wobei der erste Fehlererkennungs-Code 8 bits aufweist.

7. Verfahren nach einem der vorangegangenen Ansprüche, wobei das besagte Signal über eine Funk-Schnittstelle empfangen wird.

8. Vorrichtung zum Empfang von Datenblöcken, umfassend Mittel zur Verarbeitung, die derart angeordnet sind, dass jeder der Schritte des Verfahrens gemäß einem beliebigen der vorgenannten Ansprüche eingeleitet werden kann.

9. Basisstation für zelluläre Funkkommunikation, die eine Vorrichtung zum Empfang von Datenblöcken gemäß Anspruch 8 enthält.

10. Mobile Station für zelluläre Funkkommunikation, die eine Vorrichtung zum Empfang von Datenblöcken gemäß Anspruch 8 enthält.

# FIG.1.

FIG.2.

EP 1 473 839 B1

DÉCODER PORTION D'EN-TÊTE ⎯50

CRC1 OK ? ⎯51
OUI    NON

IDENTIFIER MS AVEC TFI ⎯53

DÉCODER PORTION DONNÉES ⎯54

55
CRC2 OK ?
OUI    NON

56
BLOC REÇU SANS ERREUR

57
MÉTRIQUE > SEUIL?
OUI    NON

BLOC REÇU AVEC ERREUR ⎯58

IGNORER SIGNAL
52

METTRE À JOUR BEP (TFI) ⎯59

FIG.3.

DÉCODER PORTION D'EN-TÊTE — 50

CRC1 OK ? — 51

OUI / NON

TFI OK ? — 63

NON

OUI

DÉCODER PORTION DONNÉES — 54

CRC2 OK ? — 55

OUI / NON

BLOC REÇU SANS ERREUR — 56

MÉTRIQUE > SEUIL? — 57

OUI / NON

BLOC REÇU AVEC ERREUR — 58

IGNORER SIGNAL — 52

METTRE À JOUR BEP (TFI) — 59

FIG.4.

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **G.D. FORNEY.** The Viterbi Algorithm. *Proc. IEEE,* Mars 1973, vol. 61 (3), 268-278